# EUROPÄISCHE PATENTANMELDUNG

(11) **EP 2 808 164 A1**
(43) Veröffentlichungstag der Anmeldung: **03.12.2014**
(21) Anmeldenummer: 13169344.2
(22) Anmeldetag: 27.05.2013
(51) Int. Cl.: B32B 17/10, H01L 31/048

(54) **Brandschutz-ausgerüstetes Solarmodul**

(71) Anmelder: BASF SE, 67056 Ludwigshafen (DE)
(72) Erfinder: Bohlander, Ralf, 40699 Erkrath (DE)
(74) Vertreter: Reinhardt, Jürgen

(57) **Zusammenfassung**

Vorgeschlagen wird ein Brandschutz-ausgerüstetes Solarmodul enthaltend
• auf der oberen Seite eine Glasscheibe (1),
• darunter einen transparenten Enkapsulanten (2), in dem elektrisch verschaltete Solarzellen eingebettet sind,
• darunter ein Brandschutzmodul (3), mit der Maßgabe, dass das Brandschutzmodul (3) ein Mehrscheibenglas aus Flachglas mit ein oder mehreren Zwischenschichten aus einem Alkalisilikatgel ist.

## Beschreibung

### Gebiet der Erfindung

Die Erfindung befindet sich auf dem Gebiet der Photovoltaik und betrifft ein Brandschutz-ausgerüstetes Solarmodul.

### Stand der Technik

Photovoltaikanlagen sind Solarstromanlagen, in denen mittels Solarmodulen - auch Photovoltaikmodule genannt - ein Teil der Sonnenstrahlung in elektrische Energie umgewandelt wird. Die Module bestehen aus Solarzellen, die in Serie oder parallel geschaltet sind, wobei die Solarzellen - auch Photovoltaikzellen genannt - die elektrischen Bauelemente sind, in denen sich die Umwandlung von Strahlungsenergie in elektrische Energie vollzieht. Solarmodule existieren in flexibler oder starre Form, wobei starre Solarmodule typischerweise auf siliziumbasierten Solarzellen basieren, die auf einen Aluminiumrahmen montiert und von einer Glasplatte abgedeckt sind. Die Solarmodule werden in Photovoltaikanlagen einzeln oder als Gruppen verschaltet.

Der typische Aufbau von Solarmodulen ist wie folgt: (a) Glasscheibe auf der zur Sonne gewandten Seite, welche unter anderem zum Schutz gegen Hagel und Verschmutzung dient, wobei häufig ein so genanntes Einscheiben-Sicherheitsglas zum Einsatz kommt; (b) transparente Kunststoffschicht, in die die Solarzellen eingebettet sind; (c) mono- oder polykristalline Solarzellen, die durch Lötbändchen elektrisch miteinander verschaltet sind; (d) Rückseitenkaschierung mit einer witterungsfesten Kunststoffverbundfolie; (e) Anschlussdose mit Freilaufdiode bzw. Bypassdiode und Anschlussterminal; (f) Aluminiumprofil-Rahmen zum Schutz der Glasscheibe bei Transport, Handhabung und Montage, sowie für die Befestigung und für die Versteifung des Verbundes.

Als Flachglas wird Glas generell dann bezeichnet, wenn es - unabhängig vom angewandten Herstellungsverfahren - in Form von Scheiben vorliegt. Flachglas wird beispielsweise im Automobilbereich, für Gewächshäuser, für Fenster, für Spiegel, für Bildschirme bzw. Displays von Computern, Fernsehern und Smartphones eingesetzt und findet auch in Photovoltaikanlagen breite Verwendung. Der Großteil des heute eingesetzten Flachglases ist das im Floatprozess erzeugte Floatglas.

Aus brandschutztechnischen Gründen werden Solarmodule so auf Dächern angebracht, dass ein Sicherheitsabstand zu den darunter liegenden Dachziegeln besteht. Gleichwohl sind Fälle aufgetreten, wo nach Kurzschlüssen aufgrund von Überspannungen ganze Dächer abgebrannt sind.

### Beschreibung der Erfindung

Die Aufgabe der vorliegenden Erfindung hat darin bestanden, ein Brandschutz-ausgerüstetes Solarmodul bereitzustellen.

Gegenstand der Erfindung ist zunächst ein Brandschutz-ausgerüstetes Solarmodul enthaltend
- auf der oberen Seite eine Glasscheibe (1),
- darunter einen transparenten Enkapsulanten (2), in dem elektrisch verschaltete Solarzellen eingebettet sind,
- darunter ein Brandschutzmodul (3), mit der Maßgabe, dass das Brandschutzmodul (3) ein Mehrscheibenglas aus Flachglas mit ein oder mehreren Zwischenschichten aus einem Alkalisilikatgel ist.

Unter der "oberen Seite" des Solarmoduls ist, dem üblichen Sprachgebrauch folgend, diejenige Seite des Solarmoduls zu verstehen, die nach fachgerechter Montage des Solarmoduls bei Tage der Sonne zugewandt ist. Unter der unteren Seite - auch Rückseite genannt - des Solarmoduls ist dem entsprechend die Gegenseite zur oberen Seite zu verstehen.

Unter einem Alkalisilikatgel wird im Rahmen der vorliegenden Erfindung eine Zusammensetzung verstanden, die aus einem oder mehreren Alkalisilikaten und Wasser besteht und die als solche eine Viskosität von mindestens 10.000 mPas (gemessen mit einem Brookfield-Viskosimeter) aufweist.

In einer Ausführungsform enthält das erfindungsgemäße Solarmodul zusätzlich eine Rückseitenkaschierung mit einer witterungsfesten Kunststoffverbundfolie.

In einer Ausführungsform ist das erfindungsgemäße Solarmodul rahmenlos.

In einer Ausführungsform beträgt das Gesamtgewicht des erfindungsmäßen Solarmoduls weniger als 15 kg/m².

### Zur Glasscheibe (1)

Bei der Glasscheibe (1) kann es sich an sich um ein beliebiges Glas handeln. Vorzugsweise wird transparentes Glas verwendet, insbesondere Floatglas. Ganz besonders bevorzugt ist transparentes eisenarmes Natronkalk-Floatglas. In einer Ausführungsform ist die Glasscheibe (1) von unten mit einem Alkalisilikat beschichtet.

### Zum Enkapsulanten (2)

Unter einem Enkapsulanten wird ein Einkapselungsmaterial verstanden, in das elektrisch untereinander verschaltete Solarzellen eingebettet sind. Der Enkapsulant wird aus einem transparenten Material gewählt. Das Material, aus dem der Enkapsulant besteht, ist vorzugsweise ein Kunststoff, insbesondere ein flexibler Kunststoff.

### Zum Brandschutzmodul (3)

Wie oben ausgeführt gilt die Maßgabe, dass das Brandschutzmodul (3) ein Mehrscheibenglas aus Flachglas (G) mit ein oder mehreren Zwischenschichten (Z) aus einem Alkalisilikatgel ist. Die einfachste Ausführungsform des Brandschutzmoduls besteht mithin aus der Anordnung G-Z-G. Es können aber auch mehrere Zwischenschichten verwendet werden, zum Beispiel Ausführungsformen mit der Anordnung G-Z-G-Z-G und G-Z-G-Z-G-Z-G.

Vorzugsweise ist das Brandschutzmoduls (3) ein Flachglas mit einer einzigen Zwischenschichten aus einem Alkalisilikatgel. Das Flachglas ist dabei insbesondere ein Floatglas.

In einer bevorzuten Ausführungsform weist das Mehrscheibenglas des Brandschutzmoduls (3) eine Dicke von weniger als 3 mm auf und insbesondere eine Dicke im Bereich von von 0,8 bis 2 mm.

In einer weiteren bevorzuten Ausführungsform weist das im Brandschutzmoduls (3) enthaltene Alkalisilikatgel einen Alkalisilikatgehalt im Bereich von 50 bis 80 Gew.-% auf.

Das im Alkalisilikatgel des Brandschutzmoduls (3) enthaltene Alkalisilikat wird vorzugsweise ausgewählt aus der Gruppe der Lithium-, Natrium und Kaliumsilikate.

In einer Ausführungsform weist das im Brandschutzmoduls (3) enthaltene Alkalisilikat ein molares SiO₂:Alk₂O-Verhältnis (Alk = Alkalimetall) im Bereich von 2 bis 10 auf. Dabei sind Natrium- und/oder Kaliumsilikate mit einem molaren SiO₂:Alk₂O-Verhältnis im Bereich von 3 bis 6 besonders bevorzugt.

In einer Ausführungsform des erfindungsgemäßen Solarmoduls wird mindestens ein Glaselement des Mehrscheibenglases des Brandschutzmoduls (3) vor der Herstellung des Mehrscheibenglases auf der der direkt angrenzenden Alkalisilikat-Zwischenschicht des Mehrscheibenglases zugewandten Seite mit Alkalisilikat in einer Schichtdicke von 10 bis 150 nm behandelt. Eine bevorzugte Weise einer solchen Beschichtung ist dabei diejenige, die in der Patentanmeldung WO 2012/037589 A2 im Beispiel 2 beschrieben ist.

In einer bevorzugten Ausführungsform ist das Brandschutzmodul (3) einer Brandklasseklasse von mindestens Brandklasse EW30 (nach EN 1363/1364) zuzuordnen.

In einer Ausführungsform ist das im Brandschutzmodul (3) enthaltene Glas ein gefärbtes Glas.

### Beispiele

### Eingesetzte Substanzen

VE-Wasser = vollentsalztes Wasser
Natrium- bzw. Kaliumsilikatlösungen (Fa. BASF)
Kieselsole: Levasil (Fa. Eka Chemicals) oder Klebosol (Fa. AZ-Chemie)
Glycerin = Pharma-Glycerin 99,8% (Fa. Pulcra).

### Mess- und Prüfmethoden

Für die folgenden Prüfungen wurden Floatglasscheiben der Fa. f-glass eingesetzt (Fläche = 500 mm x 500 mm, Dicke = 2mm) und zwar in zwei Varianten: (i) unbehandelt und (ii) mit der in der Patentanmeldung WO 2012/037589 A2 im Beispiel 2 beschriebenen Beschichtungsmethode behandelt.

### Alkali-Korrosionstest:

Glasplatten für Brandschutzanwendungen müssen alkaliresistent sein, da die erfindungsgemäßen Brandschutzgele, insbesondere die Kali-basierten, einen erhöhten pH-Wert von ca. 12 aufweisen.

Es wurden die Glasproben bei 50°C 30 min lang in 1-N KOH eingetaucht, danach mit VE-Wasser gewaschen und nach Lufttrocknung die mittlere spektrale Lichtdurchlässigkeit nach DIN EN 410 als Transparenz TR30 (= Transparenz nach 30 Minuten) der Scheibe gegen die Ursprungstransparenz TR0 gemessen. Nach Entnahme der Glasprobe wurde im Laugewasser mittels ICP-Spurenanalyse geprüft, ob sich Kieselsäure aus den Gläsern gelöst hatte, was ein Maß für die Korrosion darstellt; dabei bedeutet die bei der IPC-Spurenanalyse ermittelte ppm-Angabe das durch Korrosion des Glases in die Lauge übergegangene SiO₂.

Unbehandelte Natronkalkglasscheiben: TR0=91% / TR30=88% / ICP: 250 ppm SiO₂

Gemäß der in der Patentanmeldung WO 2012/037589 A2 im Beispiel 1 beschriebenen Beschichtungsmethode behandelte Glasscheiben aus gleicher Herstellserie (diese Behandlung wird im Folgenden auch als ARTT-Behandlung bezeichnet) ergaben folgende Daten:

| | | |
|---|---|---|
| TR0=92% | TR30=91% | ICP:45 ppm SiO₂ |

### Wasserfilmtest:

Hintergrund: Bei Lagerung und/oder Transport kann sich ein Wasserfilm in einem aufgestapelten Paket Glasscheiben bilden, welcher bei Veränderung der Gläser anderenorts die gute Haftung Glasscheibe zu Polysilikatgel stören könnte.

Methodik: Die oben genannten Glasplatten-Proben wurden 24 h lang bei Raumtemperatur in VE-Wasser getaucht. Nach Trocknung wurden die Scheiben visuell auf Veränderungen geprüft und ebenfalls die Transparenzveränderung geprüft.

Es wurden in beiden Fällen keine messbare Veränderung beobachtet: Bei den unbehandelten Gläsern (i) waren die Werte für TR0 (Ursprungswert) und TR24 (nach 24 Stunden ermittelter Wert) jeweils 91% und bei den behandelten Gläsern (ii) waren die Werte für TR0 und TR24 jeweils 92%.

### S chwitzwassertest:

Die Glasplatten-Proben wurden 140 h lang bei 60°C und einer relativen Luftfeuchtigkeit von 100% gelagert und nach Trocknung visuell beurteilt.

Es wurden in beiden Fällen keine messbare Veränderung beobachtet: Bei den unbehandelten Gläsern (i) waren die Werte für TR0 und TR140 (nach 140 Stunden ermittelter Wert) jeweils 91% und bei den behandelten Gläsern (ii) waren die Werte für TR0 und TR140 jeweils 92%.

### Herstellung von Polysilikatgelen basierend auf Kaliwasserglas und Kieselsol

### Beispiel 1

In 50 g einer hochkonzentrierten, auf unterhalb von 0,3NTU filtrierte Kaliwasserglaslösung 60 (29% SiO₂, 31 % K₂O, 40%H₂O) (Fa. BASF) wurden bei Raumtemperatur innerhalb 10 Minuten unter gutem Rühren 5 g Glycerin eingerührt. Unter auf 0,1 bar reduziertem Druck wurden über Tauchrohr in weiteren 30 Minuten 45 g Klebosol 50R50 (50% SiO₂, 50% H₂O) (Fa. AZ-chemie) eingerührt. Die fertige Mischung war bei Raumtemperatur noch etwa zwei Stunden lang dünnflüssig und konnte als chemisch härtende Gießmasse eingesetzt werden.

(Zum Begriff NTU: Der sogenannte nephelometrische Trübungswert (englisch: nephelometric turbidity unit, NTU) ist eine in der Wasseraufbereitung verwendete Einheit für Trübungsmessungen in Flüssigkeiten. Sie ist die Einheit der mit einem kalibrierten Nephelometer (Trübungsphotometer) gemessenen Trübung einer Flüssigkeit. Die hier zu Grunde liegende Norm ist die EN ISO 7027.

### Beispiel 2

In 50 g einer hochkonzentrierten, auf weniger als 0,3NTU filtrierte Kaliwasserglaslösung 55 (32% SiO₂, 21 % K₂O, 47%H₂O) (Fa. BASF) wurden bei Raumtemperatur innerhalb 10 Minuten unter gutem Rühren 2 g Glycerin eingerührt. Unter auf 0,1 bar reduziertem Druck wurden über Tauchrohr in weiteren 30 Minuten 53 g Levasil 200A/40 (40% SiO₂, 60%H₂O) (Fa. Ekachemicals) eingerührt. Die fertige Mischung war bei Raumtemperatur noch etwa eine Stunde lang dünnflüssig und konnte als chemisch härtende Giessmasse eingesetzt werden.

### Brandversuche

Es wurden Brandversuche nach EN 1363/1364 in Modulabmessungen 500 mm x 500 mm bei einer Gelschichtdiche von 1,5 mm durchgeführt und zwar unter Variation der Polysilikatgele (Gele gemäß den Beispielen 1 bzw. 2) der Art und Dicke der diese Polysilikatgele einhüllenden Gläser. Die Ergebnisse können Tabelle 1 entnommen werden. Module mit den dünneren, aber vorbehandelten Glasscheiben ergaben unveränderte Brandklassen.

**Tabelle1: Brandklassen**

| | 2x5mm ESG-Glas | 2x2mm float-Glas | 2x2mm float-Glas (ARTT-behandelt) |
|---|---|---|---|
| Gel gemäß Beispiel 1 | EW 60 | EW 35 | EW 60 |
| Gel gemäß Beispiel 2 | EW 60 | EW 45 | EW 60 |

Hinweis zu Tabelle 1: EW-Wert-Angaben gemäß der Norm EN 1363/1364.

### Fertigung von Solarmodulen

Aus 24 kristallinen Si-Solarzellen (Fa. Q-cells) pro Modul und EVA (Ethylvinylacetat, Fa. DuPont) oder Silikonharz (Fa. Wacker, Tectosil) wurden mit 2mm ARTT-behandelte Glasscheiben (Fa. f-glass, bearbeitet auf einer Lisec-HAL-flat-bed Vorspannungsanlage) mehrere Glas-Glas Solarmodule der marktüblichen Dimension 1350mm x 1000mm mit ca.190 Wp Leistung (Wp = Watt-peak) auf einem handelsüblichen Lisec-Laminator nach deren Betriebsanleitung gefertigt. Bei der Hälfte der Module wurde zusätzlich rückseitig eine Brandschutzschicht basierend auf der Mischung gemäß dem obigen Beispiel 1 und einer weiteren 2mm Glasscheibe mit auflaminiert.

Analog dimensionierte Solarmodule nach gängigem, handelsüblichem Marktstandard wurden mit EVA (Ethylen-vinyl-acetat) Enkapsulantfolien (Fa. Dupont, Elvax) und Kunststoffrückseite (Fa. Kaneka, PV Backsheet S-Type) hergestellt.

Die gefertigten Module wurden mit Acrylkleber auf eine Fichtenholz-Dachlattenkonstruktion (Höhe= 2cm, Breite = 5cm, Lattenabstand = 20cm) aufgeklebt.

Durch Dauerbeleuchtung mit Xenonlampen wurde eine Sonneneinstrahlung von 1000W simuliert. Durch schräges Auflegen eines 10cm breiten Stahlbandes auf die Moduloberfläche wurde eine Abschattung simuliert und eine hohe Spannungsdifferenz innerhalb des Moduls bzw. einzelner Zellflächen induziert. Durch Betrachtung mit einer Wärmebildkamera wurde bei allen Modulen in der belichteten Fläche zunächst ein gleichmäßiger Modultemperaturanstieg auf ca. 70°C festgestellt. Nach einigen Stunden bis Tagen traten dann stellenweise sowohl Temperaturabfälle auf ca. 50°C, aber auch einzelne Temperaturerhöhungen oberhalb von 100°C zu "Hot-Spots" auf. Beginnend bei 200°C, spätestens jedoch bei Erreichen einer Temperatur von 250°C, wurde bei den eingesetzten handelsüblichen Modulen eine gewisse Rauchentwicklung und kurz darauf eine Entzündung/Flammenbildung festgestellt. Der Brand breitete sich in alle Richtungen auf der Fläche der Modulrückseite und von dort aus auch auf die Unterkonstruktion aus Holz aus. Bei den selbst hergestellten Modulen mit EVA als Enkapsulant traten Glasrisse bei Temperaturen oberhalb von 250°C auf. Auch hier erfolgte eine leichte Flammenbildung, welche an denjenigen Stellen auf die Unterkonstruktion aus Holz übergriff, wo die Dachlatten nahe an den Hotspot-Stellen waren. Bei rückseitig mit Brandschutzgel laminierten Modulen trat in keinem Fall eine Beeinträchtigung der Unterkonstruktion aus Holz ein. Bei Tectosilverkapselten Modulen wurde nur an der Moduloberfläche eine leichte Rauchentwicklung, aber keine Flammenbildung beobachtet.

## Patentansprüche

1. Brandschutz-ausgerüstetes Solarmodul enthaltend
• auf der oberen Seite eine Glasscheibe (1),
• darunter einen transparenten Enkapsulanten (2), in dem elektrisch verschaltete Solarzellen eingebettet sind,
• darunter ein Brandschutzmodul (3), mit der Maßgabe, dass das Brandschutzmodul (3) ein Mehrscheibenglas aus Flachglas mit ein oder mehreren Zwischenschichten aus einem Alkalisilikatgel ist.

2. Brandschutz-ausgerüstetes Solarmodul enthaltend auf der oberen Seite eine Glasscheibe (1), darunter einen transparenten Enkapsulanten (2), in dem elektrisch verschaltete Solarzellen eingebettet sind, darunter ein Brandschutzmodul (3), mit der Maßgabe, dass das Brandschutzmodul (3) ein Mehrscheibenglas aus Flachglas mit ein oder mehreren Zwischenschichten aus einem Alkalisilikatgel ist.

3. Solarmodul nach Anspruch 1, wobei das Solarmodul zusätzlich eine Rückseitenkaschierung mit einer witterungsfesten Kunststoffverbundfolie enthält.

4. Solarmodul nach Anspruch 1 oder 2, wobei das Solarmodul rahmenlos ist.

5. Solarmodul nach einem der Ansprüche 1 bis 3, wobei das Mehrscheibenglas des Brandschutzmoduls (3) ein Flachglas mit einer einzigen Zwischenschichten aus einem Alkalisilikatgel ist.

6. Solarmodul nach einem der Ansprüche 1 bis 4, wobei das Flachglas des Brandschutzmoduls (3) ein Floatglas ist.

7. Solarmodul nach einem der Ansprüche 1 bis 6, wobei das Mehrscheibenglas des Brandschutzmoduls (3) eine Dicke von weniger als 3 mm aufweist.

8. Solarmodul nach einem der Ansprüche 1 bis 7, wobei das im Brandschutzmoduls (3) enthaltene Alkalisilikatgel einen Alkalisilikatgehalt im Bereich von 50 bis 80 Gew.-% aufweist.

9. Solarmodul nach einem der Ansprüche 1 bis 8, wobei das im Brandschutzmoduls (3) enthaltene Alkalisilikat ein molares SiO₂:Alk₂O-Verhältnis (Alk = Alkalimetall) im Bereich von 2 bis 10 aufweist.

10. Solarmodul nach einem der Ansprüche 1 bis 9, wobei das im Alkalisilikatgel des Brandschutzmoduls (3) enthaltene Alkalisilikat ausgewählt ist aus der Gruppe der Lithium-, Natrium und Kaliumsilikate.

11. Solarmodul nach einem der Ansprüche 1 bis 10, wobei mindestens ein Glaselement des Mehrscheibenglases des Brandschutzmoduls (3) vor der Herstellung des Mehrscheibenglases auf der der direkt angrenzenden Alkalisilikat-Zwischenschicht des Mehrscheibenglases zugewandten Seite mit Alkalisilikat in einer Schichtdicke von 10 bis 150 nm beschichtet wurde.

12. Solarmodul nach einem der Ansprüche 1 bis 11, wobei das Brandschutzmodul (3) der Brandschutzklasse von mindestens EW30 (nach EN 1363/1364) zuzuordnen ist.

13. Solarmodul nach einem der Ansprüche 1 bis 12, wobei die Glasscheibe (1) ein Floatglas ist.

14. Solarmodul nach Anspruch 13, wobei die Glasscheibe (1) von unten mit einem Alkalisilikat beschichtet ist.

15. Solarmodul nach einem der Ansprüche 1 bis 14, wobei das Gesamtgewicht des Solarmoduls weniger als 15 kg/m² beträgt.
